# EUROPÄISCHE PATENTSCHRIFT

(11) **EP 3 403 869 B1**
(45) Veröffentlichungstag und Bekanntmachung des Hinweises auf die Patenterteilung: **09.08.2023**
(21) Anmeldenummer: 18020037.0
(22) Anmeldetag: 26.01.2018
(51) Int. Cl.: B60L 53/00, B60L 53/10, B60L 53/22, B60L 53/302, B60L 53/30, H02J 7/02, H02J 7/00

(54) **KÜHLVORRICHTUNG**
COOLING DEVICE
DISPOSITIF DE REFROIDISSEMENT

(30) Priorität: 17.05.2017 DE 102017110703
(43) Veröffentlichungstag der Anmeldung: 21.11.2018
(73) Patentinhaber: Dr. Ing. h.c. F. Porsche AG, 70435 Stuttgart (DE)
(72) Erfinder: Götz, Stefan, 85659 Forstern (DE); Gross, Manuel, 74394 Hessigheim (DE)

(56) Entgegenhaltungen:
- EP-A1- 2 672 200
- EP-A2- 2 492 133
- EP-A2- 2 771 925
- EP-B1- 2 771 925
- DE-A1-102009 008 513
- DE-A1-102011 101 003
- DE-A1-102012 206 308
- FR-A1- 2 962 863
- JP-A- H07 312 805
- US-A1- 2015 054 460
- US-B1- 9 260 025
- Sophie Vorrath ET AL: "Qld-made EV fast charging technology wins EU supply deal | RenewEconomy", , 20 October 2014 (2014-10-20), XP055680550, Retrieved from the Internet: URL:https://reneweconomy.com.au/australian -ev-fast-charger-technology-wins-37000/ [retrieved on 2020-03-27]
- E-Wald: "Category", , 30 August 2016 (2016-08-30), XP055680551, Retrieved from the Internet: URL:http://wallbe.de/wp-content/uploads/20 16/08/veefil.pdf [retrieved on 2020-03-27]
- Tinyt Technology Gmbh: "Latentwärmespeicher Zur Kühlung Von Wechselrichtergebäuden", , 15 April 2017 (2017-04-15), XP055764488, Internet Retrieved from the Internet: URL:https://www.tinnit.de/index.php?cat=Um welttechnik&page=Latentw%C3%A4rmespeicher [retrieved on 2021-01-13]

## Beschreibung

Die Erfindung betrifft eine Kühlvorrichtung, insbesondere für eine Ladestation oder für einen Ladepark zum elektrischen Laden insbesondere von Kraftfahrzeugen. Auch betrifft die Erfindung ein Verfahren zum Betreiben einer solchen Kühlvorrichtung.

Ladestationen werden verwendet, um elektrische Energiespeicher, insbesondere von Kraftfahrzeugen aufzuladen. Ein Ladepark stellt eine Ansammlung einer Mehrzahl von Ladestationen dar, die beispielsweise auf einem Parkplatz oder einem Parkhaus vorgesehen ist, um auch zeitgleich eine Mehrzahl von Kraftfahrzeugen aufladen zu können.

Heutige Elektrofahrzeuge erlauben in der Regel zwei Lademodi zum Aufladen des elektrischen Energiespeichers. Ein erster Lademodus wird als AC-Lademodus bezeichnet.

Für ein Laden an einer gewöhnlichen Wechselspannungs- oder Drehstromsteckdose verfügt das Kraftfahrzeug in der Regel über ein integriertes Ladegerät, ein so genanntes On-board-Ladegerät, das die Wandlung von Wechselstrom in Gleichstrom vornimmt und den Ladebetrieb steuert. Dieser AC-Lademodus ist jedoch aufgrund der verfügbaren Anschlussleistung von in der Regel nicht mehr als 16 A oder 32 A bei etwa 230 V bzw. etwa 400 V und aufgrund des installierten Ladegerätes mit ausreichend Leistung in der Ladegeschwindigkeit enorm eingeschränkt. Hieraus ergeben sich bei heutigen Elektrofahrzeugen Ladezeiten von bis zu mehreren Stunden je 100 km Fahrstrecke.

Um diese geringen Ladegeschwindigkeiten zu verbessern ist oft auch ein sogenanntes DC-Laden mit Gleichspannung möglich. Im Gegensatz zum AC-Laden verfügt das Fahrzeug für das DC-Laden in der Regel hierfür nicht über ein eigenes Ladegerät. Stattdessen führt die fahrzeugexterne Ladesäule den Ladevorgang durch und formt ebenfalls Spannung und Strom so, wie es für das Laden der Batterie notwendig ist. Die DC-Ladeleitungen werden während des Ladevorganges direkt mit den Polen der Hochvoltbatterie des Fahrzeuges verbunden. Eine galvanische Trennung findet zwischen den DC-Ladeleitungen und der Hochvoltbatterie nicht statt. Die Leistung von DC-Ladestationen liegt bei derzeit bis zu 50 kW, was auch noch steigerungsfähig ist, um die Ladezeiten weiter zu verkürzen.

Bei Ladespannungen von bis etwa 1000 V können Ladegeschwindigkeiten von 20 km/min oder mehr erreicht werden. Damit könnte das Nachladen während Reisen in Größenordnungen gebracht werden, die Kunden vom Tanken von Verbrennungsfahrzeugen gewohnt sind. Die damit verbundenen hohen Leistungen von mehreren hundert Kilowatt erzeugen hohe Verluste in der Leistungselektronik, den Kabeln und in weiteren Komponenten in Form von Wärme. Hierzu ist eine Kühlung notwendig, um die Komponenten vor übermäßiger Wärme zu schützen.

Solche Ladestationen sind jedoch in der Regel nicht zeitlich durchgehend in Benutzung. Auch ist die nächste Benutzung der Ladestation nur sehr eingeschränkt vorhersagbar, so dass nach einer Benutzung eine unmittelbar anschließende Benutzung folgen kann oder auch eine längere Zeit der Nichtnutzung.

Ladestationen mit Kühlung werden unter anderem durch folgende Dokumente offenbart: FR2962863A1, US2015/054460A1.

Die Verwendung von Phasenübergangswärmespeichern wird durch folgende Dokumente gezeigt: "Tinyt Technology Gmbh: Latentwärmespeicher Zur Kühlung Von Wechselrichtergebäuden - XP055764488" und auch DE10 2012206308A1.

Es ist daher die Aufgabe der vorliegenden Erfindung, eine Kühlvorrichtung zu schaffen, welche den Erfordernissen der Kühlanforderungen gerecht wird und dennoch energieeffizient arbeitet. Auch ist es die Aufgabe der Erfindung ein Verfahren zum Betreiben einer solchen Kühlvorrichtung zu schaffen.

Die Aufgabe hinsichtlich der Kühlvorrichtung wird mit den Merkmalen von Anspruch 1 gelöst.

Ein Ausführungsbeispiel der Erfindung betrifft eine Kühlvorrichtung zum Kühlen einer Ladestation oder einer Mehrzahl von Ladestationen eines Ladeparks, wobei die jeweilige Ladestation einen internen Kühlmittelkanal zur Durchströmung der Ladestation mit einem Kühlmittel mit einem eingangsseitigen Kühlmittelanschluss und mit einem ausgangsseitigen Kühlmittelanschluss aufweist, mit einem Kühlmittelkreislauf mit einem Kühlaggregat zum Kühlen des Kühlmittels und mit einer Pumpe zum Pumpen des Kühlmittels in dem Kühlmittelkreislauf, wobei der Kühlmittelkanal der jeweiligen Ladestation in den Kühlmittelkreislauf integriert ist, wobei in dem Kühlmittelkreislauf ein Wärmespeicher oder eine Mehrzahl von Wärmespeichern integriert ist. Dadurch wird erreicht, dass sehr schnell Wärme abgeführt werden kann, um eine schnelle Kühlung zu erreichen, auch wenn der Kühlmittelkreislauf eine gewisse Trägheit bezüglich der Kühlung aufweist und schnelle thermische Belastungen durch plötzliche Benutzungen von einer Ladestation oder von Ladestationen nicht nachfolgen kann. Durch die Verwendung des Wärmespeichers kann der Kühlmittelkreislauf schwächer dimensioniert werden, weil Wärme mittels des Wärmespeichers schnell genug abführbar ist. Dadurch können bei der Kühlvorrichtung Einsparungen realisiert werden.

Gemäß der Erfindung sind der Wärmespeicher oder die Wärmespeicher ein Phasenwechselwärmespeicher oder ein Enthalpie-basierter thermischer Speicher.

Dadurch kann relativ schnell relativ viel Wärme gespeichert werden, weil mit dem Phasenübergang kurzfristig eine hohe Enthalpiemenge genutzt werden kann.

Auch ist es vorteilhaft, wenn der Phasenwechselwärmespeicher oder der Enthalpie-basierte thermische Speicher ein Material aufweist, welches einen Phasenübergang, eine Lösungsenhalpie, oder Ähnliches nutzt. Durch die jeweilige Form der Nutzung der Enthalpie bzw. des Phasenübergangs kann die Geschwindigkeit und die Wärmemenge definiert werden die abgeführt werden kann. So können auch mehrere Wärmespeicher genutzt werden, die unterschiedliche Geschwindigkeiten aufweisen können und unterschiedliche Wärmemengen aufnehmen können.

Auch ist es vorteilhaft, wenn das Material ein Salz, ein Salzhydrat, organische Verbindungen, insbesondere langkettige organische Verbindungen und/oder Paraffin ist oder aufweist. Dadurch können die gewünschten Phasenübergänge gezielt ausgewählt werden hinsichtlich der aufnehmbaren Wärmemenge und der Phasenübergangsgeschwindigkeit.

Besonders vorteilhaft ist es auch, wenn der Wärmespeicher oder zumindest ein Wärmespeicher im Kühlmittelkreislauf im Vorlauf der Ladestation bzw. im Vorlauf der Ladestationen angeordnet ist. Dadurch kann auch eine Unterkühlung des Kühlmittels unmittelbar vor der zu kühlenden Wärmequelle der Ladestation erreicht werden. Auch kann eine Konditionierung der Wärmequelle direkt zu Beginn des Ladevorganges zur Ausnutzung der lokal vorhandenen Wärmekapazität von Kühlmittel, einer in der Ladestation vorgesehenen Kühlplatte und/oder anderen Teilen in der Kühlkette vorgesehen werden, ohne dass die lange Verzögerung eines Umlaufes des Kühlmittels durch den gesamten Kühlmittelkreislauf abgewartet werden muss. Auch ist es dabei möglich, dass der Wärmespeicher zur Kühlung genutzt werden kann, selbst wenn ein Ausfall des Kühlmittelkreislaufs vorliegt und beispielsweise keinerlei anderweitige Rückkühlung mehr stattfindet, um beispielsweise den Ladevorgang weiterzuführen oder die Wärmequelle, wie insbesondere die Leistungselektronik, zu schützen. Dabei ist es besonders vorteilhaft, wenn der Wärmespeicher als Kühler gezielt aktivierbar ist, beispielsweise durch

Initiierung der Lösung eines Stoffes in einem Lösungsmittel, durch Aktivieren eines Phasenüberganges, beispielsweise des Schmelzvorganges durch Bereitstellen der Aktivierungsenergie, etc.

Bei einem weiteren Ausführungsbeispiel ist es zweckmäßig, wenn der Wärmespeicher oder zumindest ein Wärmespeicher im Kühlmittelkreislauf im Rücklauf der Ladestation bzw. im Rücklauf einer der Ladestationen oder im Rücklauf aller Ladestationen angeordnet ist. Dadurch wird erreicht, dass eine Verminderung der Kühlmitteltemperatur vor der nächsten Wärmequelle durchgeführt werden kann. Damit wird auch ein Schutz vor zwischenzeitlichem Überhitzen des Kühlmittels erreicht, weil es zwischen den Ladestationen bzw. zwischen den Wärmequellen wieder gekühlt werden kann. Dazu ist keine steuerbare Aktivierung des Kühlvorganges nötig. Es kann daher auch ein Material für den Wärmespeicher eingesetzt werden, das automatisch bei einer Grenztemperatur Wärme aufnimmt, beispielsweise durch Erreichen der Schmelztemperatur, und an dieser Schwelle die Temperatur des eigenen Nachlaufs stabilisiert. Alternativ kann jedoch auch ein Material verwendet werden, das gezielt steuerbar ist.

Aufgrund einer gegebenenfalls auch nur zeitweisen Nutzung des Ladeparks ist eine Unterdimensionierung des eigentlichen Kühlsystems möglich. Statt der Auslegung der Kühlleistung auf die Spitzenverlustleistung der Kühlvorrichtung zu jedem Zeitpunkt, kann die Wärmekapazität des Kühlmittelkreislaufs und der Wärmespeicher bzw. die Wärmespeicher mit einbezogen werden. Die Kühlvorrichtung ist dabei vorteilhaft zusammen mit dem Wärmespeicher oder den Wärmespeichern in der Lage, die Kühlvorrichtung bzw. das Kühlmittel bis zum Ende des Ladevorganges unter der maximalen Temperatur zu halten. Die thermische Energie, die in dem Wärmespeicher oder in den Wärmespeichern aufgenommen ist, kann anschließend in der nächsten Ladepause langsam über das Kühlaggregat wieder abgeführt werden.

Der Wärmespeicher kann auch bei einem Ausfall der Kühlvorrichtung bzw. des Kühlaggregats genutzt werden, um beispielsweise den Ladevorgang weiterzuführen oder die Wärmequelle, wie beispielsweise die Leistungselektronik, zu schützen.

So ist es auch möglich, dass der Wärmespeicher oder zumindest ein Wärmespeicher im Kühlmittelkreislauf zwischen zwei Ladestationen angeordnet ist.

Die Aufgabe hinsichtlich des Verfahrens zum Betreiben einer Kühlvorrichtung wird mit den Merkmalen von Anspruch 8 gelöst.

Ein Ausführungsbeispiel der Erfindung betrifft ein Verfahren zum Betreiben einer Kühlvorrichtung zum Kühlen einer Ladestation oder einer Mehrzahl von Ladestationen eines Ladeparks, wobei die jeweilige Ladestation einen internen Kühlmittelkanal zur Durchströmung der Ladestation mit einem Kühlmittel mit einem eingangsseitigen Kühlmittelanschluss und mit einem ausgangsseitigen Kühlmittelanschluss aufweist, mit einem Kühlmittelkreislauf mit einem Kühlaggregat zum Kühlen des Kühlmittels und mit einer Pumpe zum Pumpen des Kühlmittels in dem Kühlmittelkreislauf, wobei der Kühlmittelkanal der jeweiligen Ladestation in den Kühlmittelkreislauf integriert ist, wobei in dem Kühlmittelkreislauf ein Wärmespeicher oder eine Mehrzahl von Wärmespeichern integriert ist und die Kühlvorrichtung derart betrieben wird, dass vor und/oder bei einem Betrieb einer Ladestation Wärme in dem zumindest einen Wärmespeicher gespeichert wird. Damit wird erreicht, dass schnell Wärme abgeführt werden kann, selbst wenn der Kühlmittelkreislauf relativ träge ist.

Gemäß der Erfindung wird die gespeicherte Wärme dem Wärmespeicher über das Kühlmittel wieder entzogen, wenn die Ladestation oder zumindest eine Ladestation nicht zum Laden betrieben wird.

Auch ist es vorteilhaft, wenn eine gespeicherte Wärme dem Wärmespeicher über das Kühlmittel wieder entzogen wird, wenn die in einer Ladestation oder in den Ladestationen anfallende Wärme geringer ist als die Wärme, die durch das Kühlmittel abführbar ist.

Die Erfindung wird durch die angehängten Ansprüche definiert.

Im Folgenden wird die Erfindung anhand eines Ausführungsbeispiels unter Bezugnahme auf die Zeichnung detailliert erläutert. In der Zeichnung zeigen:
Figur 1 eine schematische Darstellung einer Kühlvorrichtung mit Kühlmittelkreislauf,
Figur 2 eine schematische Darstellung einer alternativen Kühlvorrichtung mit Kühlmittelkreislauf, und
Figur 3 eine schematische perspektivische Darstellung einer Kühlvorrichtung für eine Ladestation bzw. für einen Ladepark mit einer Mehrzahl von Ladestationen.

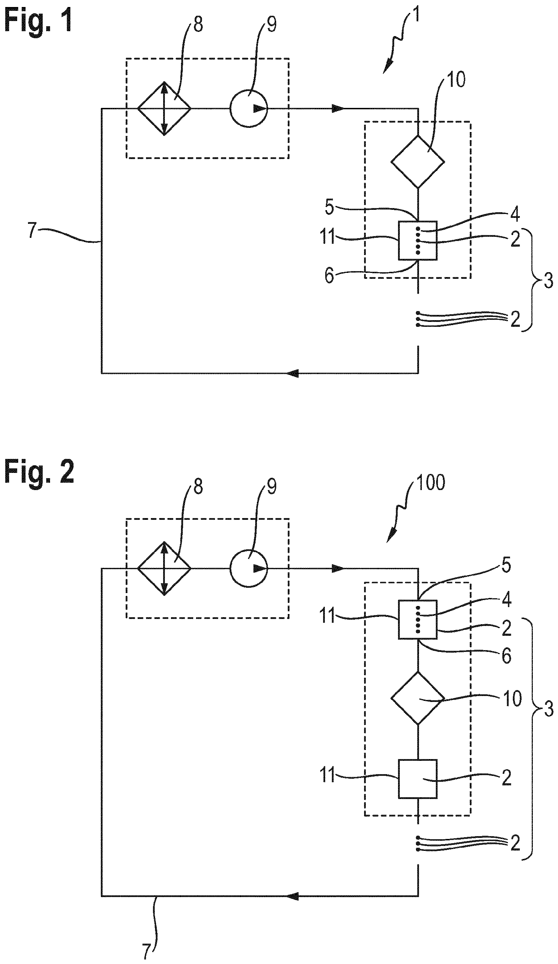

Die Figur 1 zeigt schematisch eine Kühlvorrichtung 1 zum Kühlen einer Ladestation 2 oder einer Mehrzahl von Ladestationen 2 eines Ladeparks 3.

Die jeweilige Ladestation 2 weist dabei einen internen Kühlmittelkanal 4 zur Durchströmung der Ladestation 2 mit einem Kühlmittel auf, wobei die Ladestation mit einem eingangsseitigen Kühlmittelanschluss 5 und mit einem ausgangsseitigen Kühlmittelanschluss 6 versehen ist, um den internen Kühlmittelkanal 4 der Ladestation 2 an einen Kühlmittelkreislauf 7 anzuschließen, so dass das in dem Kühlmittelkreislauf 7 strömende Kühlmittel auch durch den internen Kühlmittelkanal 4 strömen kann und dort Wärme aufnehmen kann, um die Ladestation bzw. deren Komponenten, wie insbesondere Elektronik und/oder Leistungselektronik, Kabel, Ladekabel etc., kühlen zu können. Dabei weist die Ladestation 2 bevorzugt eine Kühlplatte auf, die thermisch mit dem internen Kühlmittelkanal 4 in Kontakt steht, wobei zu kühlende Komponenten mit der Kühlplatte in thermischem Kontakt stehen.

Der Kühlmittelkreislauf 7 ist mit einem Kühlaggregat 8 zum Kühlen des Kühlmittels und mit einer Pumpe 9 zum Pumpen des Kühlmittels in dem Kühlmittelkreislauf 7 versehen, wobei der interne Kühlmittelkanal 4 der jeweiligen Ladestation 2 in den Kühlmittelkreislauf 7 integriert ist, so dass das Kühlmittel die Ladestationen seriell und/oder parallel durchströmen kann. Im Ausführungsbeispiel der Figur 1 sind die Ladestationen 2 bezüglich der Kühlmitteldurchströmung seriell angeordnet, sie können aber auch anderweitig parallel und/oder seriell verschaltet sein. Dabei können auch Gruppen von Ladestationen 2 parallel geschaltet sein, wobei in einer Gruppe die Ladestationen 2 seriell verschaltet sind.

Weiterhin ist in Figur 1 zu erkennen, dass im Vorlauf der Ladestation 2 bzw. im Vorlauf der Ladestationen 2 dem Kühlmittelkreislauf 7 ein Wärmespeicher 10 oder eine Mehrzahl von Wärmespeichern 10 integriert ist. Der Wärmespeicher 10 ist dabei bevorzugt einer Kühlplatte der Ladestation 2 vorgeschaltet. Der Wärmespeicher 10 ist dabei gegebenenfalls gesondert zu der Ladestation 2 bzw. zu den Ladestationen 2 angeordnet. Auch kann der Wärmespeicher 10 oder ein Wärmespeicher 10 in die Ladestation 2 integriert sein.

Der Wärmespeicher 10 ist bevorzugt ein Phasenwechselwärmespeicher oder ein Enthalpie-basierter thermischer Speicher, wie Wärmespeicher. Dabei weist der Phasenwechselwärmespeicher oder der Enthalpie-basierte thermische Speicher ein Material auf, welches einen Phasenübergang, eine Lösungsenthalpie, eine Reaktionsenthalpie oder Ähnliches nutzt, um Wärme speichern zu können. Dabei hängen die speicherbare Wärmemenge und die Speichergeschwindigkeit von der Wahl des Materials des Wärmespeichers ab und/oder auch von der Menge des Materials bzw. deren Anordnung bzw. Ankopplung.

Das Material des Wärmespeichers 10 kann ein Salz, ein Salzhydrat, organische Verbindungen, insbesondere langkettige organische Verbindungen und/oder Paraffin sein oder aufweisen.

Die Figur 2 zeigt ein weiteres Ausführungsbeispiel einer Kühlvorrichtung 100 zum Kühlen einer Ladestation 2 oder einer Mehrzahl von Ladestationen 2 eines Ladeparks 3.

Die jeweilige Ladestation 2 weist auch wie das Ausführungsbeispiel der Figur 1 einen internen Kühlmittelkanal 4 zur Durchströmung der Ladestation 2 mit einem Kühlmittel auf, wobei die Ladestation mit einem eingangsseitigen Kühlmittelanschluss 5 und mit einem ausgangsseitigen Kühlmittelanschluss 6 versehen ist, um den internen Kühlmittelkanal 4 der Ladestation 2 an einen Kühlmittelkreislauf 7 anzuschließen, so dass das in dem Kühlmittelkreislauf 7 strömende Kühlmittel auch durch den internen Kühlmittelkanal 4 strömen kann und dort Wärme aufnehmen kann, um die Ladestation bzw. deren Komponenten, wie insbesondere Elektronik und/oder Leistungselektronik, Kabel, Ladekabel etc., kühlen zu können. Dabei weist die Ladestation bevorzugt eine Kühlplatte auf, die thermisch mit dem internen Kühlmittelkanal 4 in Kontakt steht, wobei zu kühlende Komponenten mit der Kühlplatte in thermischem Kontakt stehen.

Der Kühlmittelkreislauf 7 ist mit einem Kühlaggregat 8 zum Kühlen des Kühlmittels und mit einer Pumpe 9 zum Pumpen des Kühlmittels in dem Kühlmittelkreislauf 7 versehen, wobei der interne Kühlmittelkanal 4 der jeweiligen Ladestation 2 in den Kühlmittelkreislauf 7 integriert ist, so dass das Kühlmittel die Ladestationen seriell und/oder parallel durchströmen kann. Im Ausführungsbeispiel der Figur 2 sind die Ladestationen 2 bezüglich der Kühlmitteldurchströmung auch seriell angeordnet, sie können entsprechend aber auch anderweitig parallel und/oder seriell verschaltet sein. Dabei können auch Gruppen von Ladestationen 2 parallel geschaltet sein, wobei in einer Gruppe die Ladestationen 2 seriell verschaltet sind.

Weiterhin ist in Figur 2 zu erkennen, dass im Rücklauf einer der Ladestation 2 bzw. zwischen zwei Ladestationen 2 in den Kühlmittelkreislauf 7 ein Wärmespeicher 10 oder eine Mehrzahl von Wärmespeichern 10 integriert ist. Der Wärmespeicher 10 ist dabei bevorzugt einer Kühlplatte der Ladestation 2 nachgeschaltet. Der Wärmespeicher 10 ist dabei gegebenenfalls gesondert zu der Ladestation 2 bzw. zu den Ladestationen 2 angeordnet. Auch kann der Wärmespeicher 10 oder ein Wärmespeicher 10 in die Ladestation 2 integriert sein.

Der Wärmespeicher 10 ist entsprechend wieder bevorzugt ein Phasenwechselwärmespeicher oder ein Enthalpie-basierter thermischer Speicher, wie Wärmespeicher. Dabei weist der Phasenwechselwärmespeicher oder der Enthalpie-basierte thermische Speicher ein Material auf, welches einen Phasenübergang, eine Lösungsenthalpie, eine Reaktionsenthalpie oder Ähnliches nutzt, um Wärme speichern zu können. Dabei hängen die speicherbare Wärmemenge und die Speichergeschwindigkeit von der Wahl des Materials des Wärmespeichers ab und/oder auch von der Menge des Materials bzw. deren Anordnung bzw. Ankopplung.

Das Material des Wärmespeichers 10 kann ein Salz, ein Salzhydrat, organische Verbindungen, insbesondere langkettige organische Verbindungen und/oder Paraffin sein oder aufweisen.

In den Figuren 1 und 2 ist der jeweiligen Ladestation 2 ein Temperatursensor 11 zugeordnet, welcher die Temperatur der Ladestation bzw. deren Komponenten, wie insbesondere deren Kühlplatte, detektiert. Das Sensorsignal des Temperatursensors dient der Steuerung der Aktivierung bzw. Deaktivierung des Wärmespeichers, wenn dieser als gezielt aktivierbarer Wärmespeicher ausgelegt ist. Dadurch kann der Phasenübergang etc. o.Ä. zeitlich gesteuert werden, um gezielt Wärme aufnehmen zu können.

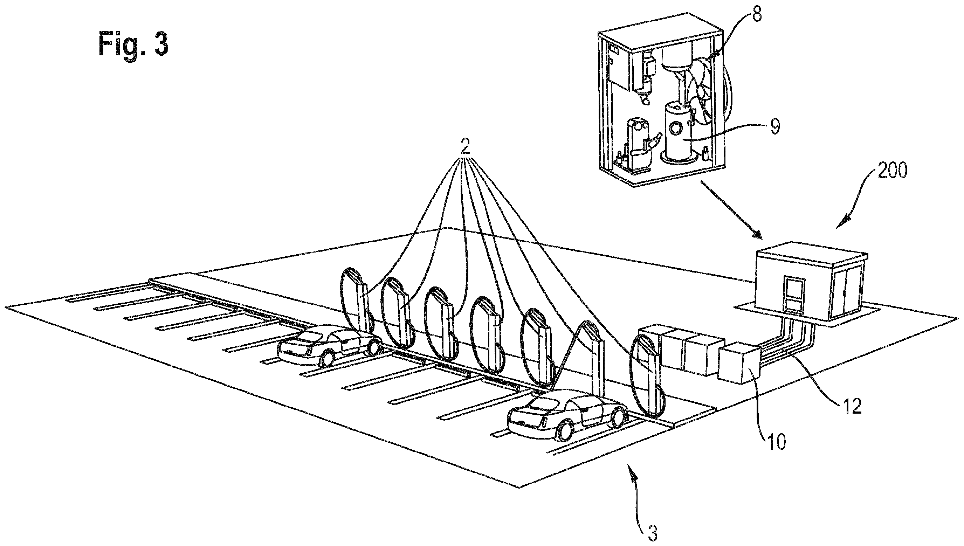

Die Figur 3 zeigt ein Ausführungsbeispiel einer Kühlvorrichtung 200 mit einem Ladepark 3 mit Ladestationen 2. Dabei ist das Kühlaggregat 8 mit Pumpe 9 bevorzugt von den Ladestationen 2 räumlich getrennt angeordnet. Das Ladeaggregat 8 und die Pumpe 9 sind in einem Kühlmittelkreislauf 7 mit Kühlmittelleitungen 12 verbunden, welche auch die Ladestationen 2 in dem Kühlmittelkreislauf 7 integrieren. Auch zu erkennen ist ein Wärmespeicher 10, der als oben beschriebener Phasenwechselspeicher bzw. Enthalpie-basierter thermischer Speicher ausgeführt ist. Dieser ist bevorzugt in einem Leistungselektronikgehäuse angeordnet, das zumindest einer Ladestation bzw. deren Leistungselektronik zugeordnet ist. Dabei ist die Leistungselektronik der Ladestation geeigneterweise nicht in die Ladestation integriert, sondern getrennt von dieser in dem entsprechenden Leistungselektronikgehäuse integriert. Auch kann die Leistungselektronik aller oder nur mancher Ladestationen in einem solchen Leistungselektronikgehäuse integriert sein. Auch können mehrere solcher Leistungselektronikgehäuse vorgesehen sein. Diese sind typischerweise in den Kühlmittelkreislauf thermisch integriert. Dabei kann nur einem der Leistungselektronikgehäuse oder allen ein Wärmespeicher 10 zugeordnet sein.

Die Erfindung betrifft auch ein Verfahren zum Betreiben einer Kühlvorrichtung 1, 100, 200 zum Kühlen einer Ladestation 2 oder einer Mehrzahl von Ladestationen 2 eines Ladeparks 3, wobei die jeweilige Ladestation 2 einen internen Kühlmittelkanal 4 zur Durchströmung der Ladestation 2 mit einem Kühlmittel mit einem eingangsseitigen Kühlmittelanschluss 5 und mit einem ausgangsseitigen Kühlmittelanschluss 6 aufweist. Dazu ist der Kühlmittelkreislauf 7 mit dem Kühlaggregat 8 zum Kühlen des Kühlmittels und mit einer Pumpe 9 zum Pumpen des Kühlmittels in dem Kühlmittelkreislauf vorgesehen. Dabei ist der Kühlmittelkanal 4 der jeweiligen Ladestation 2 in den Kühlmittelkreislauf 7 integriert. Auch ist der zumindest eine Wärmespeicher oder eine Mehrzahl von Wärmespeichern in den Kühlmittelkreislauf integriert. Die Kühlvorrichtung 1, 100, 200 wird dabei derart betrieben, dass vor und/oder bei einem Betrieb einer Ladestation Wärme in dem zumindest einen Wärmespeicher gespeichert wird. Dadurch wird eine Vorkühlung des Kühlmittels erreicht und/oder eine aktuell erzeugte Wärmemenge in dem Wärmespeicher gespeichert, um das Kühlmittel nicht so stark thermisch zu belasten. Bevorzugt erfolgt der Betrieb der Kühlvorrichtung so, dass eine gespeicherte Wärmemenge dem Wärmespeicher über das Kühlmittel wieder entzogen wird, wenn die Ladestation oder zumindest eine Ladestation nicht zum Laden betrieben wird, also keine zusätzliche oder aktuelle hohe thermische Belastung des Kühlmittels bzw. des Kühlaggregats vorliegt.

So ist es für den Betrieb auch vorteilhaft, wenn eine gespeicherte Wärmemenge dem Wärmespeicher über das Kühlmittel wieder entzogen wird, wenn die in einer Ladestation oder in den Ladestationen anfallende Wärme geringer ist als die Wärme, die durch das Kühlmittel abführbar ist.

Vorzugsweise erfolgt die Freigabe der im Phasenwechselmaterial gespeicherten Wärmeenergie bzw. Wärmemenge zu einem Zeitpunkt, zu dem keinerlei oder deutlich weniger Aktivität im Ladepark detektiert wird und somit auch eine gegenüber der installierten Leistung deutlich verringerte Ladeleistung zu erwarten ist. Die Detektion der Aktivität kann beispielsweise durch die nachfolgend beschriebenen Ereignisse erfolgen. Ferner ist auch eine Quantifizierung der Aktivität möglich:
Dabei können Bewegungssensoren ausgewertet werden, welche den Ladepark überwachen. Auch können Nutzereingaben an Usereinheiten ausgewertet werden. Auch kann eine Entnahme von Ladesteckern aus deren Aufnahme an der Ladestation ausgewertet werden. Weiterhin kann die Tageszeit berücksichtigt werden. Ebenso können Historiendaten vergangener Tage ausgewertet werden. Auch kann die Außentemperatur ausgewertet werden, weil kalte Temperaturen die elektrische Reichweite von Fahrzeugen aufgrund der von den Fahrern eingeschalteten Heizung verkürzen, ebenso verkürzen extrem heiße Außentemperaturen aufgrund der Klimaanlagennutzung die Reichweite, was ein häufigeres Laden erfordert.

Ein Ausführungsbeispiel der Erfindung kann zur Rückführung der im Phasenwechselmaterial gespeicherten Wärmeenergie bzw. Wärmemenge vorsehen, dass der Kühlmittelkreislauf bzw. das Kühlmittel durch schaltbare Ventile an einigen, beispielsweise wärmeempfindlichen Komponenten vorbeigeleitet wird, um deren Aufheizung durch die genannte Wärmeenergie zu unterbinden.

Damit werden diese Komponenten überbrückt und das erwärmte Kühlmedium wird, insbesondere möglichst direkt bzw. schnell, in den Rücklauf zurück zum Kühlsystem geleitet, das die vom Phasenwechselmaterial freigegebene Energie absorbiert.

## Patentansprüche

1. Kühlvorrichtung (1, 100, 200) zum Kühlen einer Ladestation (2) oder einer Mehrzahl von Ladestationen (2) eines Ladeparks (3), mit der Ladestation oder einer Mehrzahl von Ladestationen des Ladeparks, wobei die jeweilige Ladestation (2) einen internen Kühlmittelkanal (4) zur Durchströmung der Ladestation (2) mit einem Kühlmittel zur Kühlung von Komponenten der Ladestation, mit einem eingangsseitigen Kühlmittelanschluss (5) und mit einem ausgangsseitigen Kühlmittelanschluss (6) aufweist, mit einem Kühlmittelkreislauf (7) mit einem Kühlaggregat (8) zum Kühlen des Kühlmittels und mit einer Pumpe (9) zum Pumpen des Kühlmittels in dem Kühlmittelkreislauf (7), wobei der Kühlmittelkanal der jeweiligen Ladestation (2) in den Kühlmittelkreislauf (7) integriert ist,
wobei
in dem Kühlmittelkreislauf (7) ein Wärmespeicher (10) oder eine Mehrzahl von Wärmespeichern (10) integriert ist, **dadurch gekennzeichnet, dass** der Wärmespeicher (10) oder die Wärmespeicher (10) ein Phasenwechselwärmespeicher oder ein Enthalpie-basierter thermischer Speicher ist bzw. sind und wobei eine gespeicherte Wärme dem Wärmespeicher (10) über das Kühlmittel wieder entzogen wird, wenn die Ladestation (2) oder zumindest eine Ladestation (2) nicht zum Laden betrieben wird.

2. Kühlvorrichtung nach Anspruch 1, **dadurch gekennzeichnet, dass** eine gespeicherte Wärme dem Wärmespeicher (10) über das Kühlmittel wieder entzogen wird, wenn die in einer Ladestation (2) oder in den Ladestationen (2) anfallende Wärme geringer ist als die Wärme, die durch das Kühlmittel abführbar ist.

3. Kühlvorrichtung (1, 100, 200) nach Anspruch 1 oder 2, **dadurch gekennzeichnet, dass** der Phasenwechselwärmespeicher oder der Enthalpie-basierte thermische Speicher ein Material aufweist, welches einen Phasenübergang, eine Lösungsenthalpie oder eine Reaktionsenthalpie nutzt.

4. Kühlvorrichtung (1, 100, 200) nach Anspruch 3, **dadurch gekennzeichnet, dass** das Material ein Salz, ein Salzhydrat, organische Verbindungen, insbesondere langkettige organische Verbindungen und/oder Paraffin ist oder aufweist.

5. Kühlvorrichtung (1, 100, 200) nach einem der vorhergehenden Ansprüche, **dadurch gekennzeichnet, dass** der Wärmespeicher oder zumindest ein Wärmespeicher im Kühlmittelkreislauf im Vorlauf der Ladestation bzw. im Vorlauf der Ladestationen angeordnet ist.

6. Kühlvorrichtung (1, 100, 200) nach einem der vorhergehenden Ansprüche, **dadurch gekennzeichnet, dass** der Wärmespeicher (10) oder zumindest ein Wärmespeicher (10) im Kühlmittelkreislauf (7) im Rücklauf der Ladestation (2) bzw. im Rücklauf einer der Ladestationen (2) oder im Rücklauf aller Ladestationen (2) angeordnet ist.

7. Kühlvorrichtung (1, 100, 200) nach einem der vorhergehenden Ansprüche, **dadurch gekennzeichnet, dass** der Wärmespeicher (10) oder zumindest ein Wärmespeicher (10) im Kühlmittelkreislauf (7) zwischen zwei Ladestationen (2) angeordnet ist.

8. Verfahren zum Betreiben einer Kühlvorrichtung (1, 100, 200) zum Kühlen einer Ladestation (2) oder einer Mehrzahl von Ladestationen (2) eines Ladeparks (3), mit der Ladestation oder einer Mehrzahl von Ladestationen des Ladeparks, wobei die jeweilige Ladestation (2) einen internen Kühlmittelkanal (4) zur Durchströmung der Ladestation (2) mit einem Kühlmittel zur Kühlung von Komponenten der Ladestation, mit einem eingangsseitigen Kühlmittelanschluss (5) und mit einem ausgangsseitigen Kühlmittelanschluss (6) aufweist, mit einem Kühlmittelkreislauf (7) mit einem Kühlaggregat (8) zum Kühlen des Kühlmittels und mit einer Pumpe (9) zum Pumpen des Kühlmittels in dem Kühlmittelkreislauf (7), wobei der Kühlmittelkanal (4) der jeweiligen Ladestation (2) in den Kühlmittelkreislauf (7) integriert ist, wobei in dem Kühlmittelkreislauf (7) ein Wärmespeicher (10) oder eine Mehrzahl von Wärmespeichern (10) integriert ist und die Kühlvorrichtung (1, 100, 200) derart betrieben wird, dass vor und/oder bei einem Betrieb einer Ladestation Wärme in dem zumindest einen Wärmespeicher (10) gespeichert wird, **gekennzeichnet dadurch dass** der Wärmespeicher (10) oder die Wärmespeicher (10) ein Phasenwechselwärmespeicher oder ein Enthalpie-basierter thermischer Speicher ist bzw. sind und wobei eine gespeicherte Wärme dem Wärmespeicher (10) über das Kühlmittel wieder entzogen wird, wenn die Ladestation (2) oder zumindest eine Ladestation (2) nicht zum Laden betrieben wird.

9. Verfahren nach Anspruch 8, **dadurch gekennzeichnet, dass** eine gespeicherte Wärme dem Wärmespeicher (10) über das Kühlmittel wieder entzogen wird, wenn die in einer Ladestation (2) oder in den Ladestationen (2) anfallende Wärme geringer ist als die Wärme, die durch das Kühlmittel abführbar ist.

## Claims

1. A cooling device (1, 100, 200) for cooling a charging station (2) or a plurality of charging stations (2) of a charging park (3), with the charging station or a plurality of charging stations of the charging park, wherein the respective charging station (2) comprises an internal coolant passage (4) for passing a coolant through the charging station (2) for cooling components of the charging station, with an input-side coolant connector (5) and an output-side coolant connector (6), with a coolant circuit (7) with a cooling assembly (8) for cooling the coolant, and with a pump (9) for pumping the coolant in the coolant circuit (7), wherein the coolant passage of the respective charging station (2) is integrated into the coolant circuit (7), wherein
a heat accumulator (10) or a plurality of heat accumulators (10) are integrated in the coolant circuit (7), **characterised in that** the heat accumulator (10) or heat accumulators (10) is or are a phase-change heat accumulator or an enthalpy-based thermal accumulator, and wherein a stored heat is extracted from the heat accumulator (10) via the coolant when the charging station (2) or at least one charging station (2) is not operated for charging.

2. The cooling device according to claim 1, **characterised in that** a stored heat is extracted from the heat accumulator (10) via the coolant when the heat generated in a charging station (2) or in the charging stations (2) is less than the heat that can be dissipated by the coolant.

3. The cooling device (1, 100, 200) according to claim 1 or 2, **characterised in that** the phase-change heat accumulator or the enthalpy-based thermal accumulator comprises a material that utilises a phase transition, a solution enthalpy, or a reaction enthalpy.

4. The cooling device (1, 100, 200) according to claim 3, **characterised in that** the material is or comprises a salt, a salt hydrate, organic compounds, in particular long-chain organic compounds, and/or paraffin.

5. The cooling device (1, 100, 200) according to any one of the preceding claims, **characterised in that** the heat accumulator or at least one heat accumulator is arranged in the coolant circuit in the forward flow of the charging station or in the forward flow of the charging stations.

6. The cooling device (1, 100, 200) according to any one of the preceding claims, **characterised in that** the heat accumulator (10) or at least one heat accumulator (10) is arranged in the coolant circuit (7) in the return flow of the charging station (2) or in the return flow of one of the charging stations (2) or in the return flow of all charging stations (2).

7. The cooling device (1, 100, 200) according to any one of the preceding claims, **characterised in that** the heat accumulator (10) or at least one heat accumulator (10) is arranged in the coolant circuit (7) between two charging stations (2).

8. A method for operating a cooling device (1, 100, 200) for cooling a charging station (2) or a plurality of charging stations (2) of a charging park (3), with the charging station or a plurality of charging stations of the charging park, wherein the respective charging station (2) comprises an internal coolant passage (4) for passing a coolant through the charging station (2) for cooling components of the charging station, with an input-side coolant connector (5) and an output-side coolant connector (6), with a coolant circuit (7) with a cooling assembly (8) for cooling the coolant, and with a pump (9) for pumping the coolant in the coolant circuit (7), wherein the coolant passage (4) of the respective charging station (2) is integrated into the coolant circuit (7), wherein a heat accumulator (10) or a plurality of heat accumulators (10) are integrated in the coolant circuit (7) and the cooling device (1, 100, 200) is operated such that heat is stored in the at least one heat accumulator (10) before and/or during an operation of the charging station, **characterised in that** the heat accumulator (10) or heat accumulators (10) is or are a phase-change heat accumulator or an enthalpy-based thermal accumulator, and wherein a stored heat is extracted from the heat accumulator (10) via the coolant when the charging station (2) or at least one charging station (2) is not operated for charging.

9. The method according to claim 8, **characterised in that** a stored heat is extracted from the heat accumulator (10) via the coolant when the heat generated in a charging station (2) or in the charging stations (2) is less than the heat that can be dissipated by the coolant.

## Revendications

1. Dispositif de refroidissement (1, 100, 200) pour refroidir une station de charge (2) ou une pluralité de stations de charge (2) d'un parc de charge (3), comprenant : ladite station de charge ou une pluralité de stations de charge dudit parc de charge, la station de charge (2) respective présentant un canal de réfrigérant interne (4) qui permet la circulation de réfrigérant dans la station de charge (2) afin de refroidir les composants de la station de charge, et étant pourvue d'un raccordement de réfrigérant côté entrée (5) et d'un raccordement de réfrigérant côté sortie (6) ; et un circuit de réfrigérant (7) doté d'un groupe frigorifique (8) pour le refroidissement du réfrigérant, et d'une pompe (9) pour le pompage du réfrigérant dans le circuit de réfrigérant (7), le canal de réfrigérant de la station de charge (2) respective étant intégré dans le circuit de réfrigérant (7),
un accumulateur de chaleur (10) ou une pluralité d'accumulateurs de chaleur (10) étant intégrés dans le circuit de réfrigérant (7) ; **caractérisé en ce que** l'accumulateur de chaleur (10) ou les accumulateurs de chaleur (10) sont un ou des accumulateurs de chaleur à changement de phase ou accumulateurs thermiques à enthalpie, une chaleur accumulée étant de nouveau extraite de l'accumulateur de chaleur (10) par l'intermédiaire du réfrigérant lorsque la station de charge (2) ou au moins une station de charge (2) n'est pas exploitée pour la charge.

2. Dispositif de refroidissement selon la revendication 1, **caractérisé en ce qu'**une chaleur accumulée est de nouveau extraite de l'accumulateur de chaleur (10) par l'intermédiaire du réfrigérant lorsque la chaleur produite dans une station de charge (2) ou dans les stations de charge (2) est inférieure à la chaleur pouvant être évacuée par le réfrigérant.

3. Dispositif de refroidissement (1, 100, 200) selon la revendication 1 ou 2, **caractérisé en ce que** l'accumulateur de chaleur à changement de phase ou l'accumulateur thermique à enthalpie comprend un matériau exploitant une transition de phase, une enthalpie de solution ou une enthalpie de réaction.

4. Dispositif de refroidissement (1, 100, 200) selon la revendication 3, **caractérisé en ce que** le matériau est ou comprend un sel, un hydrate de sel, des composés organiques, en particulier des composés organiques à longue chaîne et/ou de la paraffine.

5. Dispositif de refroidissement (1, 100, 200) selon l'une des revendications précédentes, **caractérisé en ce que** l'accumulateur de chaleur ou au moins un accumulateur de chaleur est disposé dans le circuit de réfrigérant côté départ de la station de charge, voire des stations de charge.

6. Dispositif de refroidissement (1, 100, 200) selon l'une des revendications précédentes, **caractérisé en ce que** l'accumulateur de chaleur (10) ou au moins un accumulateur de chaleur (10) est disposé dans le circuit de réfrigérant (7) côté retour de la station de charge (2), voire d'une des stations de charge (2) ou de toutes les stations de charge (2).

7. Dispositif de refroidissement (1, 100, 200) selon l'une des revendications précédentes, **caractérisé en ce que** l'accumulateur de chaleur (10) ou au moins un accumulateur de chaleur (10) est disposé dans le circuit de réfrigérant (7) entre deux stations de charge (2).

8. Procédé d'exploitation d'un dispositif de refroidissement (1, 100, 200) pour refroidir une station de charge (2) ou une pluralité de stations de charge (2) d'un parc de charge (3), comprenant : ladite station de charge ou une pluralité de stations de charge dudit parc de charge, la station de charge (2) respective présentant un canal de réfrigérant interne (4) qui permet la circulation de réfrigérant dans la station de charge (2) afin de refroidir les composants de la *station de charge, et étant pourvue d'un raccordement de réfrigérant côté entrée (5) et d'un raccordement de réfrigérant côté sortie (6) ; et un circuit de réfrigérant (7) doté d'un groupe frigorifique (8) pour le refroidissement du réfrigérant, et d'une pompe (9) pour le pompage du réfrigérant dans le circuit de réfrigérant (7), le canal de réfrigérant (4) de la station de charge (2) respective étant intégré dans le circuit de réfrigérant (7), un accumulateur de chaleur (10) ou. une pluralité d'accumulateurs de chaleur (10) étant intégrés dans le circuit de réfrigérant (7), et le dispositif de refroidissement (1, 100, 200) fonctionnant de telle manière qu'avant et/ou pendant le fonctionnement d'une station de charge, de la chaleur est accumulée dans l'au moins un accumulateur de chaleur (10) ; **caractérisé en ce que** l'accumulateur de chaleur (10) ou les accumulateurs de chaleur (10) sont un ou des accumulateurs de chaleur à changement de phase ou accumulateurs thermiques à enthalpie, une chaleur accumulée étant de nouveau extraite de l'accumulateur de chaleur (10) par l'intermédiaire du réfrigérant lorsque la station de charge (2) ou au moins une station de charge (2) n'est pas exploitée pour la charge.

9. Procédé selon la revendication 8, **caractérisé en ce qu'**une chaleur accumulée est de nouveau extraite de l'accumulateur de chaleur (10) par l'intermédiaire du réfrigérant lorsque la chaleur produite dans une station de charge (2) ou dans les stations de charge (2) est inférieure à la chaleur pouvant être évacuée par le réfrigérant.
